# EUROPEAN PATENT APPLICATION

(11) **EP 4 704 524 A1**
(43) Date of publication of application: **04.03.2026**
(21) Application number: 24197037.5
(22) Date of filing: 28.08.2024
(51) Int. Cl.: H10F 39/00, H10F 39/18

(54) **A PIXEL STRUCTURE**

(71) Applicant: IMEC VZW, 3001 Leuven (BE)
(72) Inventor: BAINES, Yannick David Yann, 3000 Leuven (BE); KARVE, Gauri, 3080 Tervuren (BE)
(74) Representative: Lind Edlund Kenamets Intellectual Property AB

(57) **Abstract**

In an aspect there is provided a pixel structure (100) comprising:
a substrate (102);
a diode body (110) comprising a base portion (112) protruding from the substrate (102) and a main portion (114) on top of the base portion (112), wherein a footprint of the base portion (112) is smaller than a footprint of the main portion (114), and wherein the main portion (114) comprises first and second oppositely doped regions (120, 122) formed in a top portion (118) of the main portion (114), wherein the first doped region (120) is formed in a central part of the footprint of the main portion (114) and the second doped region (122) is formed along a periphery of the footprint of the main portion (114);
a gate (130) arranged to circumferentially surround the diode body (110), wherein the gate (130) comprises a first gate portion (132) surrounding the main portion (114) and a second gate portion (134) protruding inwardly from the first gate portion (132) to undercut the main portion (114) and surround the base portion (112);
a gate dielectric layer (136) arranged to separate the gate (130) and the diode body (110); and
a first diode terminal (140) contacting the first doped region (120), a second diode terminal (142) contacting the second doped region (122) and a gate terminal (138) contacting the gate (130)

## Description

### TECHNICAL FIELD

The present disclosure generally relates to a pixel structure, an array device, and a method for forming a pixel structure.

### BACKGROUND

In the field of imaging and sensing, silicon (Si) is the dominating platform for the visible spectrum. However, there are considerable efforts put into providing a scalable, low cost and reliable technological platform for infrared (IR) imaging and sensing applications involving wavelengths beyond 1000 nm, where absorption of silicon is low.

Automotive and mobile LIDAR, under-display cameras, augmented reality (AR) and virtual reality (VR) are examples of applications that are in strong demand for a low cost, yet efficient and mass producible infrared sensing solution.

Germanium (Ge) has a smaller bandgap than Si and a usable sensitivity to radiation in the near-infrared (NIR) and short-wavelength infrared (SWIR) regions, and is therefore an interesting material for such applications. There exists several heteroepitaxial techniques for growing crystalline Ge on Si:
1. Blanket growth whereby the Si wafer diameter defines the heteroepitaxial Ge layers size in the growth plane.
2. Selective Epitaxial Growth (SEG) whereby the heteroepitaxial layer is grown selectively in a patterned hard mask, typically silicon oxide (SiOₓ).

Blanket growth is a straightforward approach and in wide use. However, it is associated with a number of challenges when applied to large wafers, in particular 300 mm wafers. For example, the lattice mismatch between Si and Ge leads to defective epitaxial growth and thus compromised performance. Additionally, the mismatch in coefficient of thermal expansion (CTE) between Ge and Si may lead to notable bowing and warping of the wafer, which in turn may make the wafer fragile and wafer handling tedious. Secondly, substrate edge contamination is also of concern and requires specific countermeasures to ensure clean substrate edge and bevel.

SEG, on the other hand, avoids the above-mentioned issues since, due to the use of a user-defined pattern, the Ge growth is localized in islands. Therefore, SEG is a promising technique for mass production on 300 mm Si wafers, provided the use of local growth islands does not limit device design.

### SUMMARY

An issue in IR imaging and sensing applications is the presence of dark currents in the detector pixels, which contributes to imaging or sensing noise. The inventors have realized that dark carrier generation (e.g., due to the Shockley-Read-Hall mechanism) along the sidewalls of the diode body of the pixel may be especially pronounced when using Ge since the oxide hard mask of the SEG (e.g., SiOₓ) tends to be a poor passivator of the naked Ge sidewall interfaces of the diode body (SiOₓ is a more efficient passivator for Si).

In view of the above, it is an object of the present disclosure to provide a solution for a pixel structure suitable for IR imaging and sensing applications, which lends itself for efficient and rational mass production, while mitigating the issue with dark current generation and thus enabling a high sensitivity IR detector. Further and alternative objectives may be understood from the following.

According to a first aspect of the present invention, there is provided a pixel structure comprising:
a substrate;
a diode body comprising a base portion protruding from the substrate and a main portion on top of the base portion, wherein a footprint of the base portion is smaller than a footprint of the main portion, and wherein the main portion comprises first and second oppositely doped regions formed in a top portion of the main portion, wherein the first doped region is formed in a central part of the footprint of the main portion and the second doped region is formed along a periphery of the footprint of the main portion;
a gate arranged to circumferentially surround the diode body, wherein the gate comprises a first gate portion surrounding the main portion and a second gate portion protruding inwardly from the first gate portion to undercut the main portion and surround the base portion;
a gate dielectric layer arranged to separate the gate and the diode body; and
a first diode terminal contacting the first doped region, a second diode terminal contacting the second doped region and a gate terminal contacting the gate.

The pixel structure of the first aspect is based on the insight that by surrounding the diode body with a gate separated from the diode body by a gate dielectric layer, the gate may, by appropriate biasing, be used to accumulate charge carriers (electrons or holes, depending on implementation) forming an electrical field-induced layer of free charge carriers along the surface interface of the diode body facing the gate. This layer may in the following be termed "field effect-induced charge carrier layer" or, for conciseness, interchangeably "charge carrier layer". The surface interface of the diode body facing the gate may in the following be termed "the sidewall interface of the diode body". The charge carriers of the charge carrier layer may provide pinning of defects along the sidewall interface of the diode body and thus suppress a dark current contribution from the defects. The pixel structure accordingly enables defect pinning of the sidewall interface of the diode body by the field-effect. The charge carrier layer may, depending on the doping type and doping level of the main portion of the diode body be an accumulation or inversion layer.

Since the charge carrier layer is induced by the electrical field generated by the gate, the charge carrier layer may be relatively thin (e.g., about 10 nm or less). A thin charge carrier layer reduces the risk of charge carriers created by incident radiation recombining in the charge carrier layer.

The surface portions of the diode body that form part of the sidewall interface facing the gate and hence may be passivated include a surface portion of the main portion facing the first gate portion. This surface portion is in the present disclosure denoted "the first sidewall interface portion of the diode body".

Since the gate comprises not only the first gate portion, but also the second gate portion undercutting the main portion, the sidewall interface of the diode body facing the gate further comprises a surface portion of the main portion facing the second gate portion. This surface portion is in the present disclosure denoted "the second sidewall interface portion of the diode body".

Thus, the gate of the pixel structure enables defect pinning along both the first and second sidewall interface portions of the diode body. As will become apparent from the below discussion, the size of the second sidewall interface portion may depend on the implementation of the pixel structure. However, in embodiments where the footprint of the base portion is much smaller than the footprint of the main portion (e.g., where the base portion is a high aspect ratio structure), the second sidewall interface portion may constitute a major part of the footprint of the main portion (e.g., 90 % or more) and hence provide an increasing contribution to the suppression of the dark current.

Since the second gate portion further surrounds the base portion of the diode body, the sidewall interface of the diode body facing the gate may further comprise a surface portion of the base portion facing the second gate portion. This surface portion is in the present disclosure denoted "the third sidewall interface portion of the diode body".

The pixel structure of the first aspect may in principle be used with any type of semiconductors of the substrate and the diode body. For instance, the substrate may be formed of a group IV semiconductor and the diode may be formed of a group IV semiconductor or a group III-V semiconductor. However, it is contemplated that its benefits may be especially pronounced in heterostructures wherein the substrate is formed of Si, and wherein the diode body is formed of a semiconductor having a smaller bandgap than Si and hence being more prone to dark current generation. For instance, the diode body may be formed of a Ge-comprising semiconductor such as Ge, SiGe or GeSn, or a group III-V semiconductor such as GaAs, InP or InGaAs.

In some embodiments, the gate is formed of doped poly-silicon. Poly-silicon is compatible with semiconductor (e.g., Ge and Si) epitaxy growth chambers, thereby avoiding contamination issues during epitaxy of the diode body. It is furthermore heat tolerant and does hence not limit the thermal budget during fabrication. Poly-silicon is moreover transparent beyond the NIR region and absorption of IR radiation by the gate may hence be limited.

In some embodiments, the thickness of the gate dielectric layer is 50 nm or less. A thickness of the gate dielectric layer in this range allows efficient defect pinning already at modest gate voltages.

In some embodiments, the first and second diode terminals are configured to be biased with an anode voltage and a cathode voltage, respectively, or vice versa, and the gate terminal is configured to be biased with a gate voltage such that a charge carrier layer of (free) charge carriers of a same type as a majority carrier of the second doped region is formed along a surface interface of the diode body facing the gate.

The gate may thus be configured to induce a charge carrier layer (e.g., an accumulation or inversion layer) of charge carriers of a same type as a majority carrier of the second doped region in the diode body along the sidewall interface of the diode body.

In some embodiments, the charge carriers of the charge carrier layer are at least in part sourced from the second doped region or from the second doped regions, where the top portion comprises a plurality of spaced apart second doped regions.

In addition to acting as a source of majority charge carriers (electrons or holes, depending on implementation) for the diode operation, the second doped region(s) may thus act as a source for the charge carriers forming the charge carrier layer.

In some embodiments, at least a majority of the charge carriers of the charge carrier layer may be sourced from the second doped region(s).

In some embodiments, the first doped region is an N-type region, the second doped region is a P-type region, the first diode terminal is configured to be biased with a cathode voltage, the second diode terminal is configured to be biased with an anode voltage lower than the cathode voltage, and the gate terminal is configured to be biased with a gate voltage lower than the anode voltage. By this doping and biasing scheme, a charge layer of holes may be formed in an electron-based pixel structure (where "electron-based pixel structure" means that incident radiation results in an electron current to the first diode terminal).

Alternatively, in some embodiments, the first doped region is a P-type region, the second doped region is an N-type region, the first diode terminal is configured to be biased with an anode voltage, the second diode terminal is configured to be biased with a cathode voltage higher than the anode voltage, and the gate terminal is configured to be biased with a gate voltage higher than the cathode voltage. By this doping and biasing scheme, a charge layer of electrons may be formed in a hole-based pixel structure (where "hole-based pixel structure" means that incident radiation results in a hole current to the first diode terminal).

In either case, the anode, cathode and gate voltages may be applied by respective voltage sources (e.g., of the pixel structure) connected to the anode, cathode and gate terminals.

In some embodiments, a third region, being an intrinsic or low-doped region, is comprised or formed in the top portion of the diode body, circumferentially surrounding the first doped region and separating the first doped region from the second doped region. The main portion may thus be used to form a diode comprising an intrinsic region between the P- and N-regions, such as a PIN diode. Providing an intrinsic region between the P- and N-regions may increase the sensitivity of the pixel structure to incident IR radiation.

In some embodiments, the second doped region extends along the full periphery of the footprint of the main portion, to circumferentially surround the first doped region. This may facilitate inducing the charge carrier layer along the full extent of the sidewall interface and thus further contribute to reducing the dark current.

Alternatively, in some embodiments, the top portion of the main portion comprises a plurality of spaced apart second doped regions, doped oppositely to the first doped region, and distributed along the periphery of the footprint of the main portion, and each of the second doped regions is contacted with the second diode terminal. This allows reducing the diffusion of minority carriers from the (neutral) first doped region to the nearest second doped region, and vice versa, hence reducing the dark current.

In some embodiments, each second doped region of the plurality of spaced apart second doped regions is formed at a respective corner of the top portion.

In some embodiments, second doped regions are present only at the corners of the top portion. In other embodiments, second doped regions may be present also between two or more corners of the top portion.

In some embodiments, the base portion is a high aspect ratio (HAR) structure. In the present disclosure, the term "high aspect ratio structure" refers to a structure having a height-to-width ratio of at least 1.5:1, such as at least 2:1 or at least 3:1.

This may allow the diode body to be formed by epitaxy using aspect ratio trapping (ART). The ART technique allows trapping of dislocations originating from lattice mismatch between the substrate (e.g., of Si) and the base portion (e.g., of Ge). Thereby, such dislocations may be trapped and confined in the base portion, wherein the main portion may be formed with a high material quality.

A further advantage brought about by ART is that the defect pinning may be provided along a relatively large proportion of the second sidewall interface portion of the diode body since the footprint of the base portion may be kept small relative the footprint of the main portion. This may further suppress a diffusion current and hence contribute to a reduced dark current.

Where the base portion is a HAR structure, the footprint of the base portion may for instance be at most 10 % of the footprint of the main portion.

In some embodiments, the base portion is a low aspect ratio (LAR) structure. In the present disclosure, the term "low aspect ratio structure" refers to a structure having a height-to-width ratio of less than 1.5:1, such as 1: 1 or less, 1:2 or less, or 1:5 or less. The diode body may hence be formed also using non-ART SEG techniques.

In some embodiments, the base portion comprises a doped bottom portion abutting the substrate, the doped bottom portion being of a same conductivity type as the second doped region. Defect pinning may hence be provided also along the surface interface of the diode body facing (more specifically abutting) the substrate. This part of the surface interface of the diode body may in the following be termed "the bottom interface of the diode body". Defect pinning may hence be provided substantially along all surface interfaces of the diode body (the top interface being a possible exception). Doping of the bottom portion of the base portion may in particular be effective for dark current suppression where the diode-substrate interface is relatively large, as the case may be with a LAR base portion, where the footprint of the base portion may be greater than 10 % of the footprint of the main portion.

In some embodiments, the pixel structure further comprises a gate metal layer arranged over the gate and contacting the gate terminal, wherein the gate metal layer extends inwardly from a location above the first gate portion to overlap the periphery or a peripheral region of the footprint of the main portion. The gate metal layer may hence in effect allow the gate and gate potential to "wrap around" the periphery of the top portion of the main portion of the diode body, and thus extend the charge carrier layer along a top surface of the main portion of the diode body. Thus, the electrostatically induced defect pinning may be extended to encompass also a portion of the top surface of the main portion.

According to a second aspect there is provided an array device comprising a plurality of pixel structures according to the first aspect or any embodiments thereof, wherein the pixel structures are arranged in a plurality of rows and columns.

The array device may be suitable for use as an IR detector in IR imaging and sensing applications, with the benefits discussed above.

According to a third aspect, there is provided a method for forming a pixel structure, comprising:
forming on a substrate, a diode device comprising:
   a diode body comprising a base portion protruding from the substrate and a main portion on top of the base portion, wherein a footprint of the base portion is smaller than a footprint of the main portion, and wherein the main portion comprises first and second oppositely doped regions formed in a top portion of the main portion, wherein the first doped region is formed in a central part of the footprint of the main portion and the second doped region is formed along a periphery of the footprint of the main portion;
   a gate arranged to circumferentially surround the diode body, wherein the gate comprises a first gate portion surrounding the main portion and a second gate portion protruding inwardly from the first gate portion to undercut the main portion and surround the base portion;
   a gate dielectric layer arranged to separate the gate and the diode body;
wherein the diode body is formed using a selective epitaxial growth process subsequent to forming the gate and the gate dielectric layer.

Thereby, a pixel structure in accordance with the first aspect may be formed by first forming a gate structure comprising the gate and the gate dielectric layer, and thereafter growing the diode body on the substrate using a selective epitaxial growth process.

The gate structure and the diode body may be formed in an aperture in a patterned hard mask.

A hard mask layer may be formed on the substrate. A main aperture exposing the substrate may be formed in the hard mask layer, to form the patterned hard mask.

Forming the gate structure may comprise depositing a gate layer in the main aperture and a first partial gate dielectric layer on the gate layer. An auxiliary opening with a smaller footprint than the main aperture and exposing the substrate may be formed in the first partial gate dielectric layer and the gate layer. A second partial gate dielectric layer may subsequently be formed along sidewalls of the main aperture and the auxiliary opening. Each of the gate layer, the first partial gate dielectric layer and the second partial gate dielectric layer may be conformally deposited.

After forming the gate structure, the diode body may be epitaxially grown in the auxiliary and main apertures. The diode body may more specifically be grown from a surface portion of the substrate exposed in the auxiliary aperture.

In some embodiments, after forming the diode body using the selective epitaxial growth process, the first and second doped regions may be formed in the top portion of the main portion using respective ion implantation processes.

In some embodiments, the method further comprises forming a first diode terminal contacting the first doped region, a second diode terminal contacting the second doped region and a gate terminal contacting the gate.

### BRIEF DESCRIPTION OF THE DRAWINGS

The above, as well as additional objects, embodiments, features and advantages of the present disclosure, may be better understood through the following illustrative and non-limiting detailed description, with reference to the appended drawings.
Fig. 1a-b show a schematic side view and top-down view, respectively, of a pixel structure.
Fig. 2-9 show variants of the pixel structure with different layouts of the first and/or second doped regions in the diode body.
Fig. 10-11 show further variants of the pixel structure with differently shaped diode bodies.
Fig. 12 shows a schematic side view of a further pixel structure.
Fig. 13-14 show two variants of array devices comprising arrays of pixel structures.
Fig. 15a-b show a schematic side view and top-down view, respectively, of a pixel structure and a layout of a gate metal layer.
Fig. 16a-c and Fig. 17a-c show two variants of array devices comprising gate metal layers and diode metal layers with different layouts.
Fig. 18a-e schematically illustrate various stages of a method for forming a pixel structure.
Fig. 19a-e schematically illustrate various stages of a further method for forming a pixel structure.

### DETAILED DESCRIPTION

In the drawings, like reference numerals will be used for like or corresponding elements unless stated otherwise. The drawings are only schematic and the relative dimensions of illustrated elements, such as layers or other structures, may be exaggerated and not drawn to scale unless stated otherwise. Rather the dimensions may be adapted for illustrational clarity and to facilitate understanding. When present in the figures, the indicated axes X, Y and Z point in a first horizontal direction, a second horizontal, and a vertical direction, respectively.

In the present disclosure, the term "horizontal" refers to a direction parallel to a substrate of the pixel structure or device, i.e. parallel to a main surface of the substrate. The term "lateral" may be used interchangeably with the term "horizontal". The term "vertical" refers to a direction normal or transverse to the substrate. Accordingly, terms indicating relative vertical arrangement of elements, such as "top", "upper", "bottom", "lower" and the like, are to be understood in relation to the vertical direction relative the substrate.

In the present disclosure terms such as "first" and "second" etc. with reference to features (elements or process steps) are used only as labels to facilitate distinguishing between features, and need not necessarily imply that they have different significance, or that they should be arranged or performed in any particular order, unless stated otherwise.

In the present disclosure, when an element (e.g. a layer or other structure) is referred to as being "on" another element, it can be directly on the other element or on one or more intermediate elements on the other element. Conversely, when an element is referred to as being "directly on" another element, there is no intermediate element and the element is thus formed in physical contact or abutment with the other element. Correspondingly, an interface between two elements implies that the elements are abutting, i.e., in physical contact with each other.

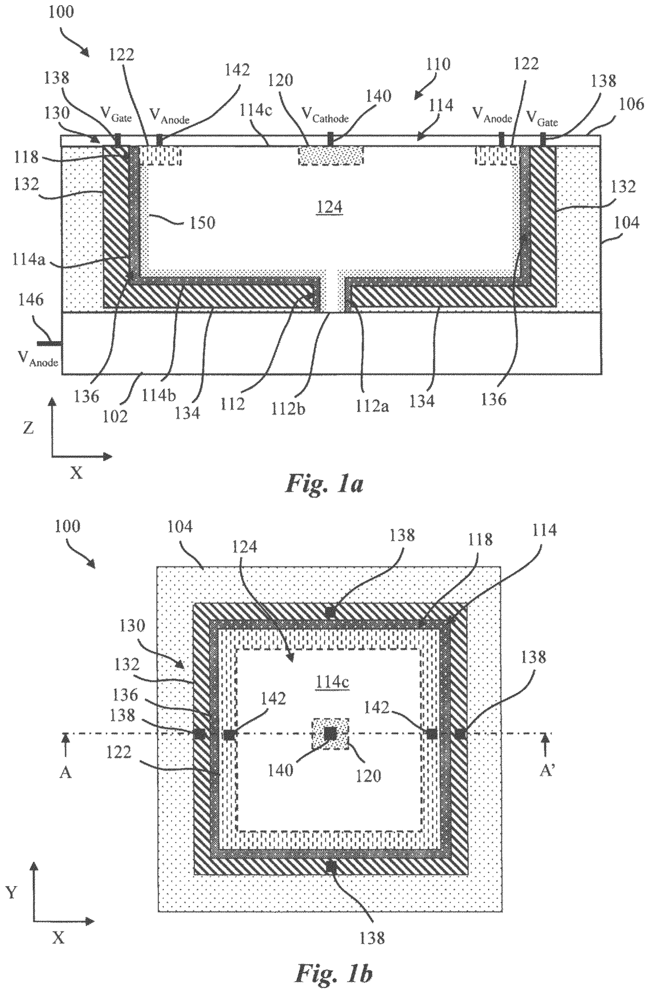

Fig. 1a-b show a schematic side view and top-down view, respectively, of a pixel structure 100. In particular, Fig. 1a shows a cross-sectional side view of the pixel structure 100 taken along line A-A' indicated in Fig. 1b.

The pixel structure 100 comprises a substrate 102, a diode body 110 and a gate 130. The substrate 102 extends in parallel to the horizontal XY-plane. The diode body 110 comprises a base portion 112 protruding from the substrate 102 along the Z direction and a main portion 114 on top of the base portion 112. The base portion 112 is arranged or formed in abutment with a surface portion of the substrate 102. A footprint of the base portion 112 is smaller than a footprint of the main portion 114. In the present disclosure, the "footprint" of the main portion 114 and the base portion 112 refers to their respective footprints as seen in a horizontal plane, i.e., in a plane parallel to the substrate 102. The base portion 112 is substantially centered within the footprint of the main portion 114.

The footprint of the main portion 114 is substantially square-shaped, as may be seen in Fig. 1b. The footprint of the base portion 112 may also be substantially square-shaped. However, the footprint of the base portion 112 may also be of a different shape than the main portion 114, such as a non-square rectangular-shaped footprint, a rounded (e.g., circular) footprint or a polygonal footprint.

The main portion 114 comprises a surface interface portion 114a facing the gate 130 (first sidewall interface portion 114a), a surface interface portion 114b facing the gate 130 (second sidewall interface portion 114b) and a top interface 114c. The top interface 114c defines the top interface or top surface portion of the diode body 110. The base portion 112 comprises a surface portion 112a facing the gate 130 (third sidewall interface portion 112a) and a surface portion 112a interfacing with the substrate 102 (bottom interface 112b). The bottom interface 112b defines the bottom interface or bottom surface portion of the diode body 110.

The gate 130 is arranged to circumferentially surround the diode body 110. The gate 130 comprises a first gate portion 132 and a second gate portion 134. The first gate portion 132 extends in a substantially vertical direction and surrounds the main portion 114 of the diode body 110. The first gate portion 132 thus extends along the first interface portion 114a of the main portion 114. The second gate portion 134 protrudes inwardly in a substantially horizontal direction from a bottom of the first gate portion 132 to undercut the main portion 114 and surround the base portion 112. The second gate portion 134 thus extends along the second interface portion 114b of the main portion 114.

A gate dielectric layer 136 is further arranged to circumferentially surround the diode body 110, i.e., surround in a horizontal plane. The gate dielectric layer 136 is arranged between the diode body 110 and the gate 130 to separate the gate 130 and the diode body 110. The gate dielectric layer 136 and the diode body 110 are arranged in direct contact such that an interface is defined therebetween. The interface extends along the sidewall interface of the diode body 110, comprising the first sidewall interface portion 114a of the main portion 114, the second sidewall interface portion 114b of the main portion 114, and the third sidewall interface portion 112a of the base portion 112.

The gate 130 may be formed of (highly) doped poly-silicon, however a metal gate is also possible. The gate dielectric layer 136 may be formed with a thickness of 50 nm or less. The gate dielectric layer 136 may be formed by an oxide, e.g., such as SiO₂. However, also a high-k gate dielectric, such as HfO₂ or AlOₓ is possible.

For conciseness, the term "diode device" may in the following be used to refer to the combination of the diode body 110, the gate 130 and the gate dielectric 136.

The diode device may as shown further be surrounded by an insulating layer 104. The insulating layer 104 may typically be an oxide such as SiOₓ (e.g., SiO₂), or some other conventional type of interlayer dielectric (e.g., of low-k). The diode device may more specifically be arranged or formed in an aperture or cavity of the insulating layer 104. Thus, the diode device may be encased in the insulating layer 104.

The diode device, and more specifically the top interface 114c of the main portion 114 of the diode body 110, may as shown further be covered by a passivation layer 106, typically also an oxide such as GeOₓ or AlOₓ, for passivating the top interface 114c. The passivation layer 106 is omitted from Fig. 1b to not obscure the underlying features of the pixel structure 100.

In the illustrated example, it is assumed that the pixel structure 100 is a heterostructure, wherein the substrate 102 and the diode body 110 are formed of different semiconductors. For example, the substrate 102 may be formed of Si and the diode body 110 may be formed of a smaller bandgap semiconductor, such as Ge, SiGe, GeSn, GaAs, InP or InGaAs, or a stack of GaAs/InGaAs or InP/InGaAs. Thereby, the pixel structure 100 being suitable for IR imaging and sensing applications may be realized on a Si-platform.

The diode body 110 may be epitaxially grown on the substrate 102, i.e., formed in an epitaxy process. The diode body 110 may more specifically be formed by selective epitaxial growth (SEG), wherein the diode body 110 may be grown from a seeding surface of the substrate 102 within an aperture in a patterned hard mask. If the hard mask is formed of an oxide or another interlayer dielectric, the hard mask may remain in the finished pixel structure 100 to define the insulating layer 104.

As will be further discussed below, the diode body 110 may be formed after forming the gate 130 and the gate dielectric layer 136 within the aperture. Thus, the gate 130 and the gate dielectric layer 136 may substantially conform to the profile of the aperture as defined by the sidewalls of the aperture (defined by the patterned hard mask) and the bottom surface of the aperture (defined by the substrate 102). The orientation of the first gate portion 132 may thus correspond to the orientation of the sidewalls of the aperture.

In the illustrated example, the base portion 112 of the diode body 110 forms a high-aspect ratio (HAR) structure. Thereby, the diode body 110 may be realized using the ART technique. Dislocations originating from a lattice mismatch between the substrate 102 and the diode body 110 may thereby be gradually reduced as the epitaxial growth proceeds. For a given height-to-width ratio of the base portion 112, with a sufficient height of the base portion 112, the dislocations may substantially be trapped within the base portion 112, such that a main portion 114 substantially free of dislocations may be obtained. In general, a greater height-to-width ratio may confer a stronger dislocation trapping. However, as may be appreciated, the specific value of the height-to-width ratio of the base portion 112 may depend on various factors, such as the amount of lattice mismatch between the substrate material and the diode body material, a targeted dislocation concentration in the main portion 114, a maximum total height of the diode body 110 over the substrate 102, a target size of the footprint of the main portion 114, etc. For instance, assuming a Si substrate 102 and a Ge diode body 110, the base portion 112 may be formed with a width of 100 to 300 nm and a height of 300 nm to 1.5 µm. In any case, where the base portion 112 is a HAR structure, the footprint of the base portion 112 will typically be considerably smaller than the footprint of the main portion 114, such as at most 10 % of the footprint of the main portion 114. An example method for forming a pixel structure using ART will be described in further detail below.

As further shown in Fig. 1a-b, the main portion 114 of the diode body 110 comprises first and second doped regions 120, 122 formed in a top portion 118 of the main portion 114. The first and second doped regions 120, 122 are oppositely doped. In the illustrated example, it is assumed that the first doped region 120 is an N-type region and the second doped region 122 is a P-type region, however the opposite configuration is also possible.

The first doped region 120 is formed in a central part of the footprint of the main portion 114. The second doped region 122 extends along the full periphery of the footprint of the main portion 114, to circumferentially surround the first doped region 120. Thus, as may be seen most clearly in the top-down view of Fig. 1b, the second doped region 122 extends along the full perimeter of the top interface / surface 114c of the main portion 114.

The first and second doped regions 120, 122 are separated by a third region 124 circumferentially surrounding the first doped region 120. The third region 124 may be an intrinsic or low-doped region to realize a PIN-diode, or more generally a region with a lower doping concentration than each of the first and second doped regions 120, 122.

The first and second doped regions 120, 122 may be formed by selectively introducing N- and P-type dopants, respectively, into the top portion 118 of the main portion 114. For example, the dopants may be introduced using ion implantation from the top interface 114c. The first and second doped regions 120, 122 may also be formed using diffusion or re-growth.

The respective doping concentrations of the first and second doped regions 120, 122 may be chosen in view of the semiconductor material of the diode body 110 and desired levels of quantum efficiency, dark current and gain, to mention a few non-limiting example parameters that may be considered. For example, a respective doping concentration of the first and second doped regions 120, 122 may be 10¹⁸ cm⁻³ or greater (i.e., of N-type dopants in the first region 120 and of P-type dopants in the second doped region 122). A doping concentration of the third region 124 may for instance be 10¹⁷ cm⁻³ or less. Where the base portion 112 is a HAR structure, the base portion 112 may typically, like the third region 124 be an intrinsic, low-doped region of the diode body 110, or at least lower doped than the first and second doped regions 120, 122. The substrate 102 may be an intrinsic substrate or a doped substrate of a same conductivity type as the second doped region 122, i.e., in the present example a P-type region. In the case of an intrinsic substrate 102 or a low-doped substrate (e.g., less than 10¹⁸ cm⁻³), a high-doped region (e.g., higher than 10¹⁸ cm⁻³) of a same conductivity type as the second doped region 122 may be formed in the substrate 102 (e.g., a surface implantation layer) where the diode body 110 abuts the substrate 102.

The respective depths of the first and second doped regions 120, 122 (i.e., relative the top interface 114c, as seen along the vertical dimension, e.g., determined by the depth of the respective ion implantations) as shown in Fig. 1a are merely schematic examples, and both shallower and deeper doping profiles relative the height (i.e., the vertical dimension) of the main portion 114 may be implemented in practice. Furthermore, in Fig. 1a, the respective depths of the first and second doped regions 120, 122 are depicted as substantially equal. However, in practice, the first and second doped regions 120, 122 may extend to different depths in the main portion 114. In any case, the respective depths of the first and second doped regions 120, 122 will typically be less than the height of the main portion 114, such that a lower doped or intrinsic region of the main portion 114 remains underneath the first and second doped regions 120, 122.

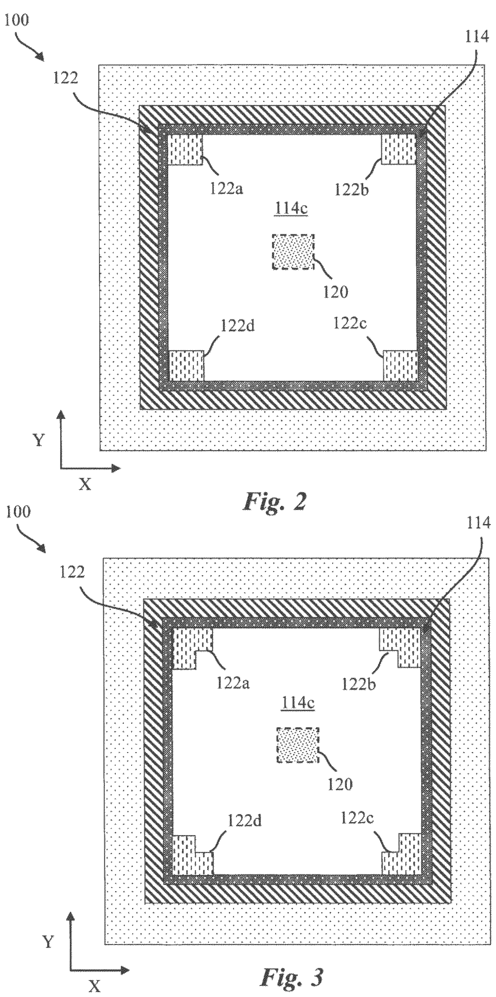

Further, the respective surface areas of the footprints of the first and second doped regions 120, 122 (i.e., their respective surface areas along the top interface 114c) as shown in Fig. 1a are merely schematic examples, and may be dimensioned differently, both relative to each other and relative to the full surface area (i.e., footprint) of the top interface 114c (e.g., see the further examples of Fig. 2-11 discussed below).

The pixel structure 100 further comprises a first diode terminal 140 contacting the first doped region 120, a second diode terminal 142 contacting the second doped region 122) and a gate terminal 138 contacting the gate 130. As shown, more than one second diode terminal 142 may be provided for contacting the circumferentially extended second doped region 122. Additionally, more than one gate terminal 138 may be provided for contacting the gate 130, such as along one or more sides of the gate 130 as shown in Fig. 1b. The substrate 102 may further be connected to a substrate terminal 146, as schematically indicated in Fig. 1a. The terminals 138, 140, 142 may be formed of any conventional contact metals typically employed for gate and diode terminals, respectively, such as tungsten (W). The terminals 138, 140, 142 may extend through the passivation layer 106 to make contact with the gate 130 and the first and second regions 120, 122, respectively.

In use of the pixel structure 100, the gate 130 may be biased so as to accumulate charge carriers to form a field effect-induced charge carrier layer 150 along the sidewall interface of the diode body 110, including the first, second and third sidewall interface portions 114a, 114b and 112a.

As mentioned above, in the present example, the first doped region 120 is an N-type region and the second doped region 122 is a P-type region. Thus, by biasing the first diode terminal 140 with a cathode voltage V_{Cathode}, the second diode terminal 142 with an anode voltage V_{Anode} which is lower than the cathode voltage V_{Cathode}, and the gate terminal 138 with a gate voltage V_{Gate} lower than the anode voltage V_{Anode}, the gate voltage V_{Gate} may attract charge carriers in the form of holes to form a charge carrier layer 150 of holes. If the third region 124 is an intrinsic region, or a (low-doped) region of a same conductivity type as the second doped regions 122 (e.g., P-type in the present example), the charge carrier layer 150 may form an accumulation layer. If the third region 124 is a (low-doped) region of a same conductivity type as the first doped region 120 (e.g., N-type in the present example), the charge carrier layer 150 may form an inversion layer. In either case, the holes of the charge carrier layer 150 may provide defect pinning along the sidewall interface of the diode body 110. Thereby, a dark current contribution from any defects along the sidewall interface may be suppressed.

The charge carriers (holes) of the charge carrier layer 150 will at least in part be sourced from the P-type second doped region 122. An additional source of the charge carriers may include holes from the P-doped substrate 102 or, as may be the case, a P-doped region of the substrate 102. However, due to the band offset between the material of the substrate 102 (e.g., Si) and the material of the diode body 110 (e.g., Ge) and the absence of a corresponding band offset between the second doped region 122 and the third region 124, it is contemplated that at least a majority of the charge carriers of the charge carrier layer 150 will be sourced from the second doped region 122.

The anode, cathode and gate voltages may be supplied to the pixel structure 100 by respective voltage sources of diode driver circuitry associated with the pixel structure 100. The diode driver circuitry may for instance be comprised in peripheral circuitry of an array device comprising the pixel structure 100.

As a non-limiting and representative example, the diode body 110 may be formed of Ge and the substrate may be a P-type Si substrate 102. The gate may be a poly-silicon gate with a P-type doping. The doping concentration of the substrate 102 and the poly-silicon gate may each be about 10¹⁸ cm⁻³. The first doped region 120 may be an N-type region with a doping concentration of about 5*10¹⁸ cm⁻³. The second doped region 122 may be a P-type region with a doping concentration of about 5*10¹⁸ cm⁻³. The cathode voltage V_{Cathode} (i.e., the voltage applied to N-region via the first diode terminal) may be +3V, the anode voltage V_{Anode} (i.e., the voltage applied to the P-region via the second diode terminals) may be 0V, and the gate voltage V_{Gate} (i.e., the voltage applied to the P-region via the second diode terminals) may be -3V. This may result in a nanometer thin hole accumulation layer 150 along the sidewall interface of the diode body 120. The hole concentration of the hole accumulation layer 150 will be at its maximum closest to the gate dielectric layer 136 and gradually diminish moving into the bulk of the diode body 110.

Considering as an illustrative comparative example a passivation approach employing chemical doping from the sidewall interfaces of the diode body. This would tend to create broad doping profiles extending considerably further into the diode body than the hole accumulation layer. In addition to creating a larger volume where a risk of recombination of hole-pairs created by incident radiation (lowering the light detection efficiency), the broad doping profile would create a correspondingly large neutral region in the diode body. Neutral regions facilitate diffusion of minority carriers between the N- and P-regions. This is undesirable as diffusion currents contribute to the dark current of the pixel structure. Chemical doping by ion implantation may further create defects inside the diode body which are not cured even after an implantation activation anneal. These defects may in turn be an additional source of dark current. Thus, by the electrostatically induced hole accumulation layer, defect pinning may be provided while avoiding these issues associated with chemical doping of the sidewall interfaces.

Returning to Fig. 1a-b, analogous results may be obtained where the conductivity types of the first and second doped regions 120, 122 are flipped such that the first doped region 120 forms a P-type region and the second doped region 122 forms an N-type region. The substrate 102 may in this case be an N-type substrate or an intrinsic or low-doped substrate comprising a high-doped N-type region in abutment with the base portion 112 of the diode body 110. Thus, by biasing the first diode terminal 140 with an anode voltage V_{Anode}, the second diode terminal 142 with a cathode voltage V_{Cathode} higher than the anode voltage V_{Anode}, and the gate terminal 138 with a gate voltage V_{Gate} higher than the cathode voltage V_{Cathode}, the gate voltage V_{Gate} may attract charge carriers in the form of electrons to form the charge carrier layer 150, i.e., a charge carrier layer 150 of electrons. The electrons of the charge carrier layer 150 may thus, analogous to the above discussion of the charge carrier layer 150 of holes, provide defect pinning along the sidewall interface of the diode body 110, and thus suppress a dark current contribution from any defects therealong. The charge carriers (electrons) of the accumulation layer 150 may in this case at least in part (typically at least a majority) be sourced from the N-type second doped region 122. An additional source of the charge carriers may include the N-doped substrate 102.

For instance, the anode voltage V_{Anode} may be 0V, the cathode voltage V_{Cathode} may be +3V and the gate voltage V_{Gate} may be +6V. However, other combinations of voltages are also possible. For instance, the anode voltage V_{Anode} may be -3V, the cathode voltage V_{Cathode} may be 0V and the gate voltage V_{Gate} may be +3V.

It is here noted that the examples of the anode, cathode and gate voltages presented above, both where the first doped region 120 is N-type and the second doped region 122 is P-type, and vice versa, are to be considered as illustrative but non-limiting examples. The skilled person would, based on the examples herein, be able to adapt the anode, cathode and/or gate voltages in view of factors and parameters that may vary with application, material systems, doping levels, etc., without departing from the present disclosure.

Fig. 2-9 show top-down views of variants of the pixel structure 100 with different layouts of the first and/or second doped regions 120, 122 within the plane of the top interface 114c. In each of the following variants, it is to be understood that the first and second doped regions 120, 122 are oppositely doped (e.g., N-type and P-type, respectively, or vice versa). Apart from differences in layout, the discussion of the first and second doped regions 120, 122 in connection with Fig. 1a-b applies correspondingly to the first and second doped regions 120, 122 of the following variants.

Fig. 2 shows a variant wherein the pixel structure 100, instead of comprising a second doped region 122 extending along the full periphery of the footprint of the main portion 114, comprises a plurality of spaced apart second doped regions 122a-d (collectively indicated by reference sign 122) distributed along the periphery of the footprint of the main portion 114. That is, the second doped regions 122 are distributed along the perimeter of the top interface 114c. Each second doped region 122a-d is formed at a respective corner of the top interface 114c. Each second doped region 122a-d has a substantially rectangular shape, e.g., a square.

Fig. 3 shows a further variant wherein the second doped regions 122a-d, instead of having a rectangular shape, each are extended by a distance along edges of the top interface 114c.

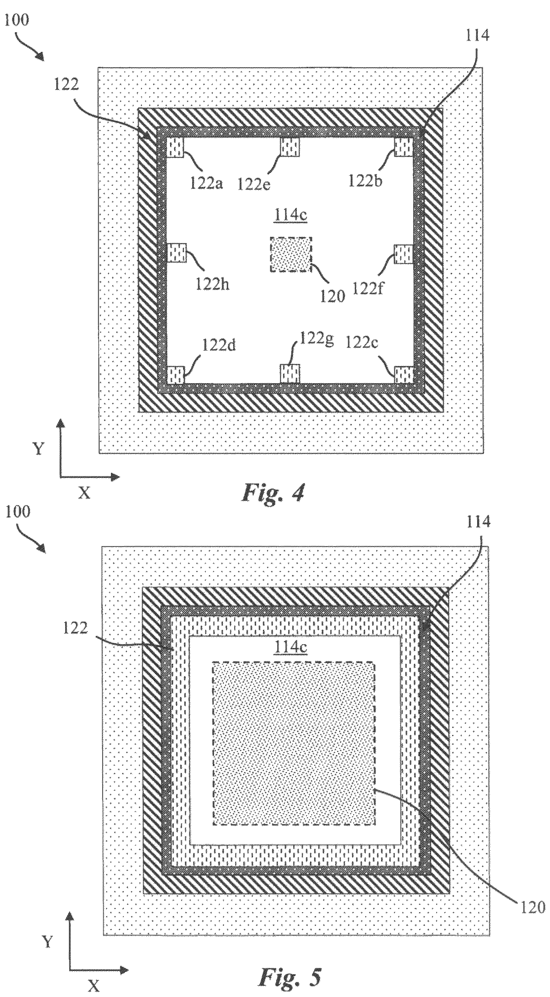

Fig. 4 shows a further variant wherein in addition to second doped regions 122a-d at the corners of the top interface 114c, additional second doped regions 122e-h are formed between the corners. The second doped regions 122a-h are distributed with a substantially uniform separation along the perimeter of the top interface 114c, with each additional second doped region 122e-h being located approximately halfway between a respective pair of corners of the top interface 114c.

Fig. 5 shows a further variant wherein the second doped region 122 is configured like in Fig. 1b, however, a greater portion of the top interface 114c is occupied by the first doped region 120. More specifically, the footprint (i.e., surface area) of the first doped region 120 covers a major portion of the top interface 114c. The footprint of the first doped region 120 exceeds the footprint of the second doped region 122. A possible benefit of a larger first doped region 120 is that it generates a larger neutral region which may help to reduce a dark current contribution from the top interface 114c. A possible increase in diffusion current caused by a larger neutral region in the diode body 110 may if needed be countered by forming the diode body 110 of SiGe with a minor portion of Si, such as Si_{0.04}Ge_{0.96}.

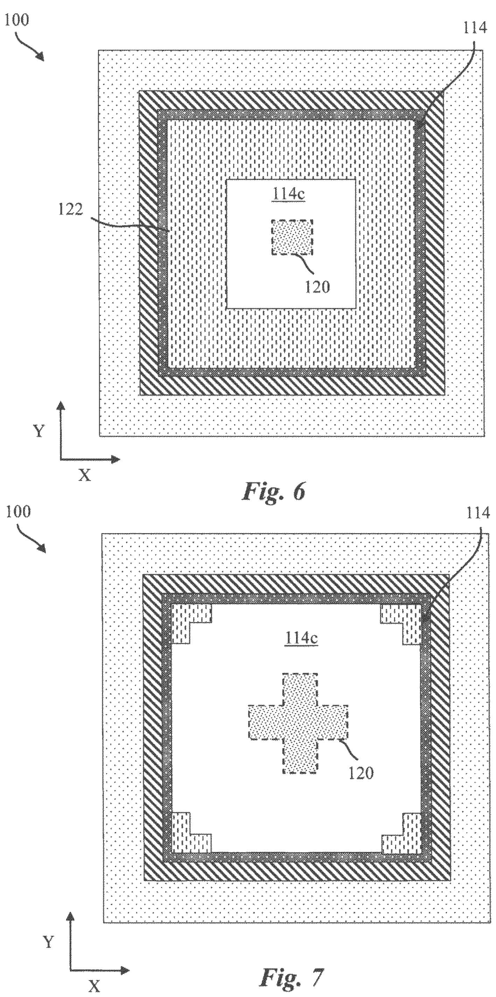

Fig. 6 shows a further variant wherein instead a greater portion of the top interface 114c is occupied by the second doped region 122. More specifically, the footprint (i.e., surface area) of the second doped region 122 covers a major portion of the top interface 114c. The footprint of the second doped region 122 exceeds the footprint of the first doped region 120. The further discussion of the variant in Fig. 5 applies correspondingly to this variant.

Fig. 7-9 show further variants with differently shaped first doped regions 120.

In Fig. 7, the first doped region 120 has a footprint in the shape of a cross.

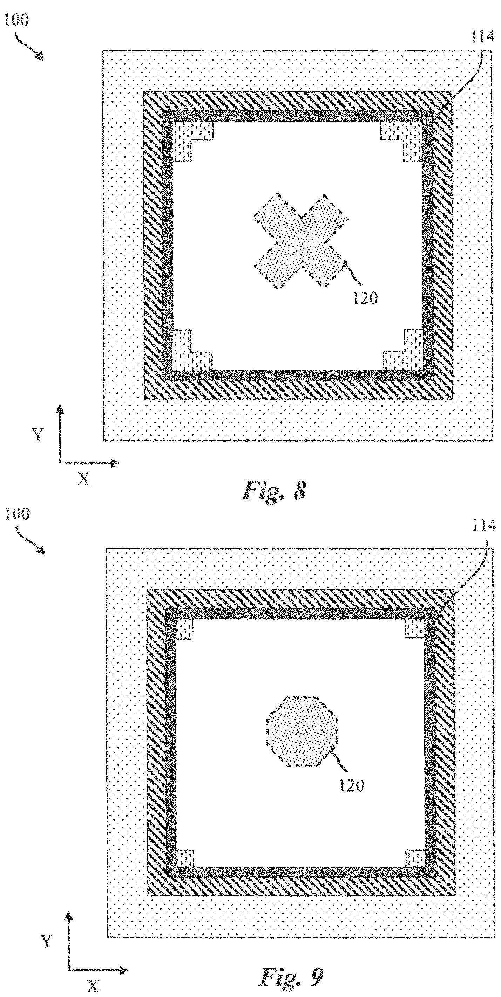

In Fig. 8, the first doped region 120 also has a footprint in the shape of a cross, however angled 45 degrees relative the perimeter of the top interface 114c.

In Fig. 9, the first doped region 120 is formed with facets, to define a substantially octagonal shape.

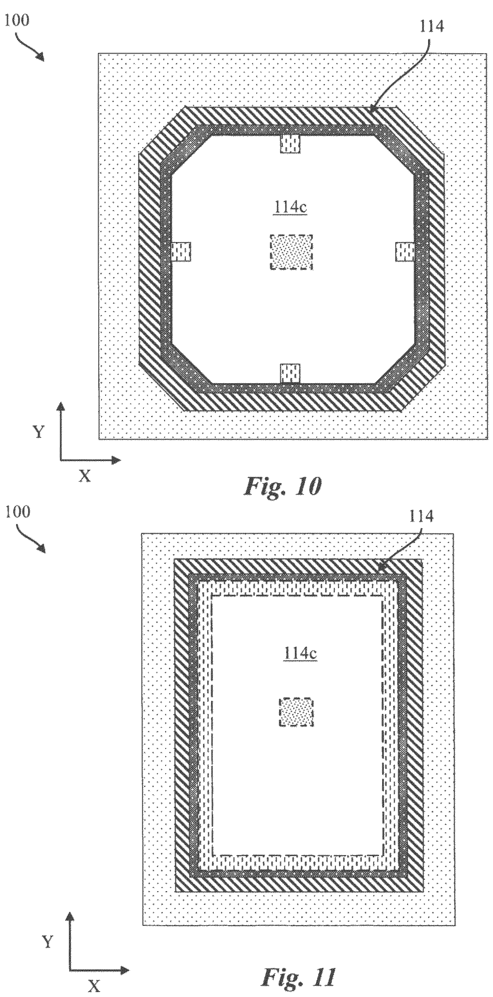

Fig. 10-11 show further variants of the pixel structure 100 with diode bodies having differently shaped footprints.

In Fig. 10, the footprint of the main portion 114 is faceted, to define a substantially octagonal shape.

In Fig. 11, the footprint of the main portion 114 has a substantially rectangular non-square footprint.

The operation of the variants of the pixel structure 100 shown in Fig. 2-11 may proceed analogously to the discussion with reference to Fig. 1a-b. Thus, upon application of appropriate voltages to the first and second diode terminals 140, 142 and the gate terminal 138, a charge carrier layer (of holes or electrons) corresponding to the charge carrier layer 150 shown in Fig. 1a may be formed along the surface interface of the diode body. In the variants comprising a plurality of second doped regions 122, the charge carriers of the charge carrier layer may be sourced at least in part (typically predominantly) from the plurality of second doped regions 122.

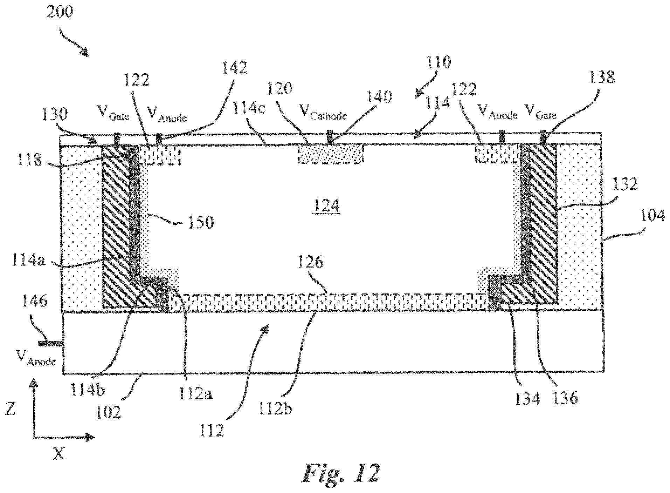

Fig. 12 shows a schematic side view of a further pixel structure 200. The pixel structure 200 generally corresponds to the pixel structure 100 of Fig. 1a-b, however differs in that the base portion 112 of the diode body 110 does not define a HAR structure, but a low-aspect ratio (LAR) structure. This implementation may be used in cases where ART is not used to form the diode body 110.

Thus, the diode body 110 of the pixel structure 200 may, unlike the diode body 110 of the pixel structure 100, be formed by a non-ART SEG process, and, like the diode body 110 of the pixel structure 100, be grown from a seeding surface of the substrate 102 within an aperture in a patterned hard mask, e.g., corresponding to the insulating layer 104. While a non-ART process may result in a greater concentration of dislocations in the main portion 112 of the diode body 110 than an ART process, an effect with non-ART process may be that less vertical overgrowth of the diode body 110 is required. This may facilitate realizing denser arrays of pixel structures. A further possible benefit of employing a non-ART process may be that the larger interface between the base portion 112 and the substrate 102 may make the pixel structure 200 more suitable for use in a back side illuminated (BSI) configuration. An example method for forming a pixel structure using a non-ART process will be described in further detail below.

For a LAR base portion 112, the footprint may typically be closer to the footprint of the main portion 114 than in a case where the base portion is a HAR structure. For instance, the footprint of the LAR base portion 112 may be in a range of more than 10 % of the footprint of the main portion 112, such as 50 % or more, or 90 % or more.

A greater footprint of the base portion 112 implies a greater interface between the diode body 110 and the substrate 102. Compared to the relatively small interface between the diode body 110 and the substrate 102 of the pixel structure 100, passivation of defects along the diode body-substrate interface of the pixel structure 200 may have a greater impact in terms of dark current suppression. Therefore, the base portion 112 of the diode body 110 of the pixel structure 200 may as shown be provided with a doped bottom portion 126 abutting the substrate 102. The doped bottom portion 126 is doped to a same conductivity type as the second region 122 (e.g., a P-type region). The doped bottom portion 126 may be doped by in-situ doping during the epitaxy of the diode body 110.

While doping of the doped bottom portion 126 may provide defect passivation, it may further cause forming of a neutral region in the base portion 112. A neutral region may allow an increased diffusion of minority charge carriers that in turn may contribute to an increased diffusion current through the diode body 110 and thus an increased dark current. However, also with the LAR structure base portion 112 of the pixel structure 200, the footprint of the base portion 114 is in any case still smaller than the footprint of the main portion 112, thus reducing the size of the diode body-substrate interface. Meanwhile the second gate portion 134 may provide passivation of the second interface portion 114a of the main portion 114. In the case of a BSI pixel implementation, the footprint of the base portion 112 may further be designed based on factors such as the focusing efficiency of the microlens on the backside for SWIR light.

The various layouts of the first and second doped regions 120, 122, and the different shapes of the main portion 112 discussed with reference to the pixel structure 100 and Fig. 1-11, may be applied correspondingly to the pixel structure 200.

A plurality of pixel structures such as the pixel structure 100 or 200 may be combined to form an array device.

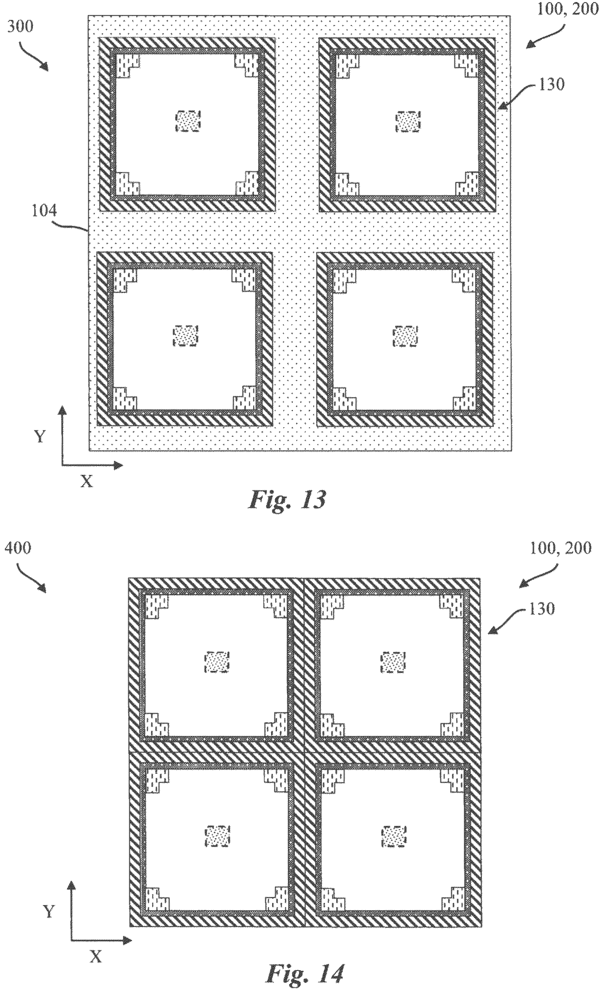

Fig. 13 shows an array device 300 comprising an array of identically configured pixel structures, each configured in accordance with the pixel structure 100 or 200. The pixel structures 100, 200 are arranged in a plurality of rows and columns. Each pixel structure 100, 200 comprises a respective gate 130, spaced apart from the respective gates of its neighboring pixel structures. Thus, each pixel structure 100, 200 is surrounded by a portion of the insulating layer 104.

Fig. 14 shows a further array device 400 which like the array device 300 comprises an array of identically configured pixel structures, each configured in accordance with the pixel structure 100 or 200. The array device 400 however differs from the array device 300 in that the gate 130 is shared by the pixel structures 100, 200. This may facilitate realizing denser arrays of pixel structures since the pixel structures may be more closely spaced.

Fig. 13 and 14 show only two-by-two arrays, however as may be appreciated an array device 300 or 400 may in practice comprise a considerably greater number of rows and columns. In an image sensor array implementation for an IR camera, the array size of the array device 300 or 400 may for instance be 320 x 240, 640 x 480, or greater.

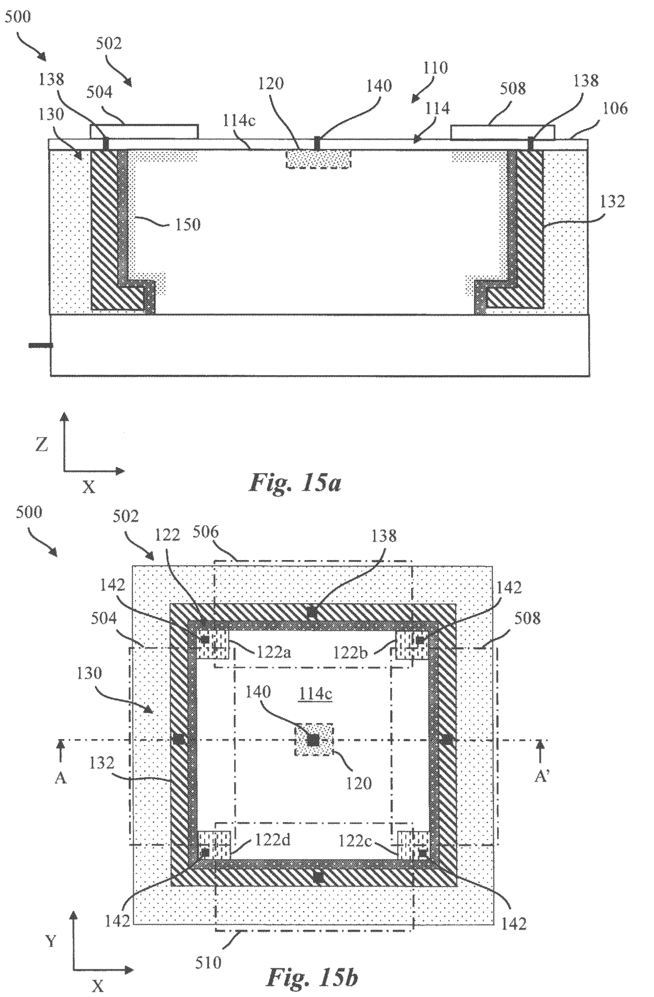

Fig. 15a-b show a schematic side view and top-down view, respectively, of a further pixel structure 500. The diode body 110 of the pixel structure 500 is similar to the diode body 110 of the pixel structure 200 comprising the LAR structure base portion 112. However, the following discussion of the pixel structure 500 is applicable also to a pixel structure comprising a diode body having a HAR structure base portion, such as the pixel structure 100.

The pixel structure 500 comprises a gate metal layer 502. The gate metal layer 502 is arranged over the gate 130 and the diode body 110. The gate metal layer 502 is arranged to contact the gate terminals 138, which as shown in Fig. 15b may be provided on top of one or more sides of the gate 130. The gate metal layer 502 may in turn be connected to a gate voltage source via an interconnect structure arranged over the gate metal layer 502, (e.g., a back-end-of-line interconnect structure), as per se is known in the art. The gate metal layer 502 may be formed of Cu or some other conventional metal typically employed for back-end-of-line metal interconnects.

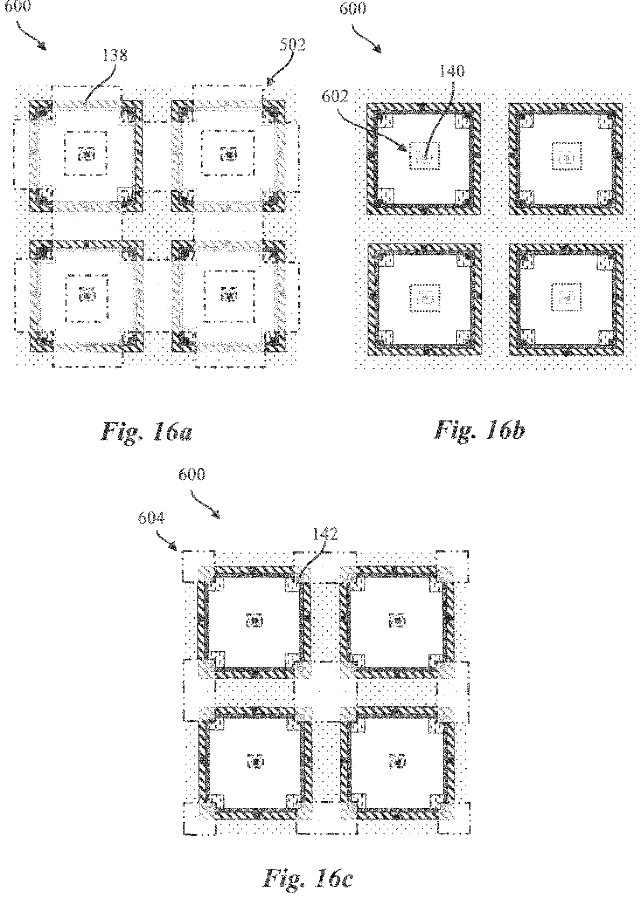

The gate metal layer 502 comprises gate metal layer portions 504, 506, 508, 510. The gate metal layer portions 504, 506, 508, 510 are in Fig. 16b shown with a dashed outline to allow a view of the underlying portions of the pixel structure 500.

While the gate metal layer portions 504, 506, 508, 510 are shown as respective and partially overlapping portions, it is to be noted that the gate metal layer portions 504, 506, 508, 510 in practice will be part of a continuous metal layer and be formed using a same mask.

Each gate metal layer portion 504, 506, 508, 510 extends inwardly in a horizontal direction from a location above (i.e., overlapping) the first gate portion 132 towards a center of the diode body 110, to overlap (i.e., define an overhang over) a peripheral region of the footprint of the main portion 114, i.e., a peripheral region of the top interface 114c. The gate metal layer 502 is separated from the top interface 114c by the passivating layer 106. Thus, upon being biased by the gate voltage (e.g., V_{Gate} as discussed in connection with Fig. 1a-b), the gate metal layer 502 may attract and accumulate charge carriers to the top interface 114c. Thereby, the charge carrier layer 150 may be extended along the peripheral region of the top interface 114c to provide defect pinning of the top interface 114c.

It is contemplated this configuration in particular may be useful where the main portion 112 is provided with a plurality of spaced apart second doped regions 122. This since even where the second doped regions 122 are spaced apart from each other, the charge carrier layer 150 enables the anode potential (e.g., V_{Anode}) to be extended along the periphery of the top interface 114c. Further, since the charge carrier layer 150 does not result in forming of a neutral region (as in the second doped regions 122), the minority carrier concentration may be substantially zero. The extension of the charge carrier layer 150 along the top interface 114c need hence not contribute to an increased diffusion current.

Since the passivating layer 106 in this configuration is further to function as a gate dielectric, the thickness of the passivating layer 106 should be chosen accordingly. For instance, the passivating layer 106 may be formed with a thickness of 50 nm or less.

The metal layer 502 may further provide a function of acting as a back reflector where the pixel structure 500 is used as a BSI pixel, thus increasing the light collection efficiency of the diode 110.

The gate metal layer portions 504, 506, 508, 510 may as shown define an opening or aperture over a central part of the top interface 114c, including the first doped region 120. The opening in the gate metal layer 502 allows the first doped region 120 and the first diode terminal 140 to be electrically accessed from above. The opening in the gate metal layer 502 may further allow the pixel structure 500 to be used as a front side illuminated (FSI) pixel, as the opening then may act as a light entrance aperture, allowing light to impinge on the top interface 114c from a frontside of the pixel structure 500.

The gate metal layer portions 504, 506, 508, 510 may as shown further define peripheral openings over a part of each second doped region 122 and a respective second diode terminal 142 contacting the same. The peripheral openings in the gate metal layer 502 allows the second doped regions 122 and the second diode terminals 142 to be electrically accessed from above.

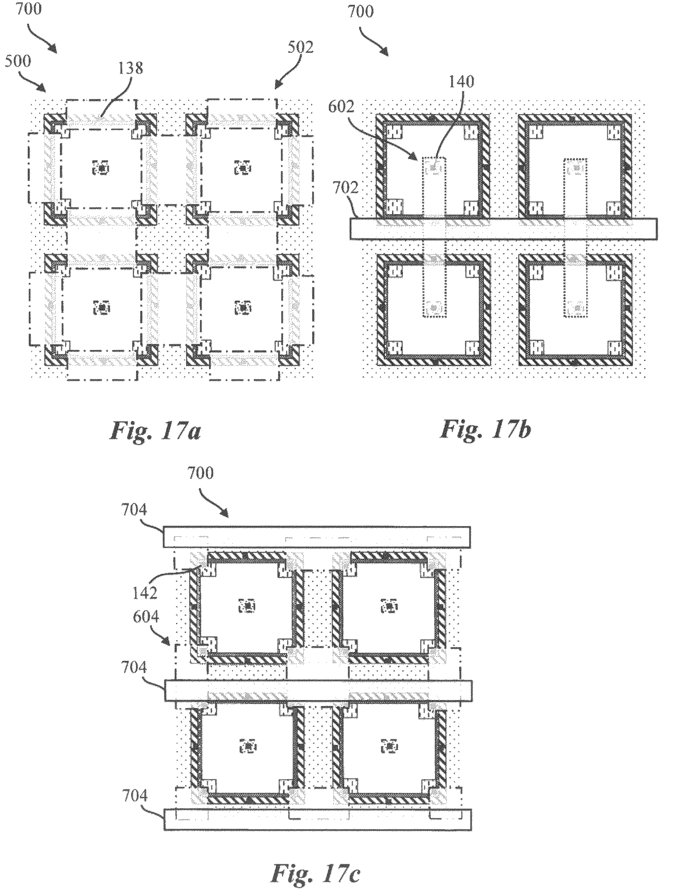

Fig. 16a-c and Fig. 17a-c show two variants of array devices comprising gate metal, anode and cathode layers with different layouts.

Fig. 16a-c shows an array device 600 comprising four pixel structures, each substantially configured in accordance with the pixel structure 500 of Fig. 15a-b. The array device 600 comprises a gate metal layer 502, a first diode metal layer 502 and a second diode metal layer 604, each of which for illustrational clarity are separately shown in Fig. 16a-c, respectively. The gate metal layer 502, the first diode metal layer 602 and the second diode metal layer 604 are indicated using different outlines (i.e., dash-dotted, dotted, and dash-dotted-dotted lines, respectively) and in a partially transparent fashion to allow a simultaneous view of underlying features. The first and second diode metal layers 602, 604 may like the gate metal layer 502 be formed of Cu or some other conventional metal typically employed for back-end-of-line metal interconnects.

As shown in Fig. 16a, portions of the gate metal layer 502 may be shared between neighboring pixel structures 500.

As shown in Fig. 16b, the first diode metal layer 602 is connected to the first diode terminals 140. As shown in Fig. 16c, the second diode metal layer 604 is connected to the second diode terminals 142. Hence, where the first doped regions 120 and second doped regions 122 of the diode bodies of the respective pixel structures 500 define N- and P-type regions respectively, the first diode metal layer 602 may be configured as a cathode metal layer and the second diode metal layer 604 may be configured as an anode metal layer. In the opposite configuration, the first diode metal layer 602 may be configured as an anode metal layer and the second diode metal layer 604 may be configured as a cathode metal layer.

The gate metal layer 502, the first diode metal layer 602 and the second diode metal layer 604 may be arranged on different levels over the pixel structures 500. For instance, the first diode metal layer 602 and the second diode metal layer 604 may be arranged at a same level, or at respective levels, over the gate metal layer 502.

The configuration of the array device 600 provides, as may be seen, a relatively large metal coverage of the front side of the array device 600. The array device 600 may therefore be suitable for a BSI device.

Fig. 17a-c show a further array device 700 with a smaller metal coverage. The array device 700 may therefore be suitable for a FSI device. For simplicity, a same outline and a same set of reference signs are used to indicate the gate metal layer 502, the first diode metal layer 602 and the second diode metal layer 604 as in Fig. 16a-c. As may be seen in Fig. 17a, the gate metal layer 502 is here arranged to overlap a smaller part of the respective top interfaces of the diode bodies. Additionally, as shown in Fig. 17b the first diode metal layer 602 is shared between neighboring pixel structures. This allows the first diode metal layer 602 and second diode metal layers 604 to be connected to respective first and second diode buses 702, 704 (e.g., cathode and anode buses) shown in Fig. 17b and 17c, respectively, arranged between the rows of pixel structures, thus minimizing shadowing of the diode bodies from the front side. The first and second diode buses 702, 704 may be arranged at a same level, or respective levels, above the first and second diode metal layers 602, 604.

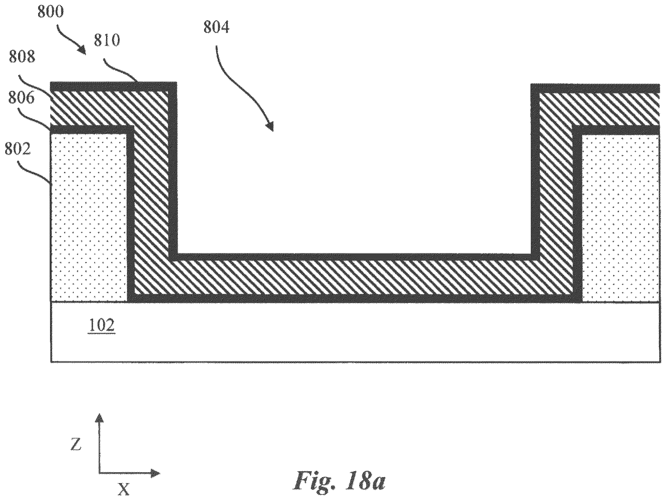

Fig. 18a-f schematically illustrate various stages of a method for forming a pixel structure using an ART-based approach, such as a pixel structure corresponding to the pixel structure 100 of Fig. 1a-b.

Fig. 18a shows an initial structure 800 which is to be subjected to further steps of the method to form a final pixel structure.

A hard mask 802 has been formed on a substrate 102 and patterned to define a main aperture 804. The hard mask 802 may for instance correspond to the insulating layer 104 discussed above and be formed of an oxide such as SiO₂.

The main aperture 804 may be formed using a conventional lithography and etching process.

A gate layer 808 has been formed, e.g., conformally deposited, in the aperture 804. The gate layer 808 may be formed of poly-Silicon. The gate layer 808 may be deposited using for instance chemical vapor deposition (CVD) or atomic layer deposition (ALD). The gate layer 808 may be doped, either using an in-situ process or by ion implantation and/or anneal.

A first partial gate dielectric layer 810 has subsequently been formed in the main aperture 804 on top of the gate layer 808, e.g., e.g., conformally deposited. The first partial gate dielectric layer 810 may be formed of an oxide, such as SiO₂ or a high-k gate dielectric, such as HfO₂ or AlOₓ. The first partial gate dielectric layer 810 may for instance be deposited using CVD or ALD.

Further, prior to forming the gate layer 808, an insulating interfacial layer 806 may be formed, e.g., conformally deposited, in the main aperture 804. The interfacial layer 806 may be formed of an oxide, such as SiO₂. The interfacial layer 806 may for instance be deposited using CVD or ALD. The gate layer 808 may accordingly be formed on top of the interfacial layer 806. An interfacial layer may serve to electrically isolate the gate layer 808 from the substrate 102. It may further protect the substrate 102 from process conditions during the forming and doping of the gate layer 808.

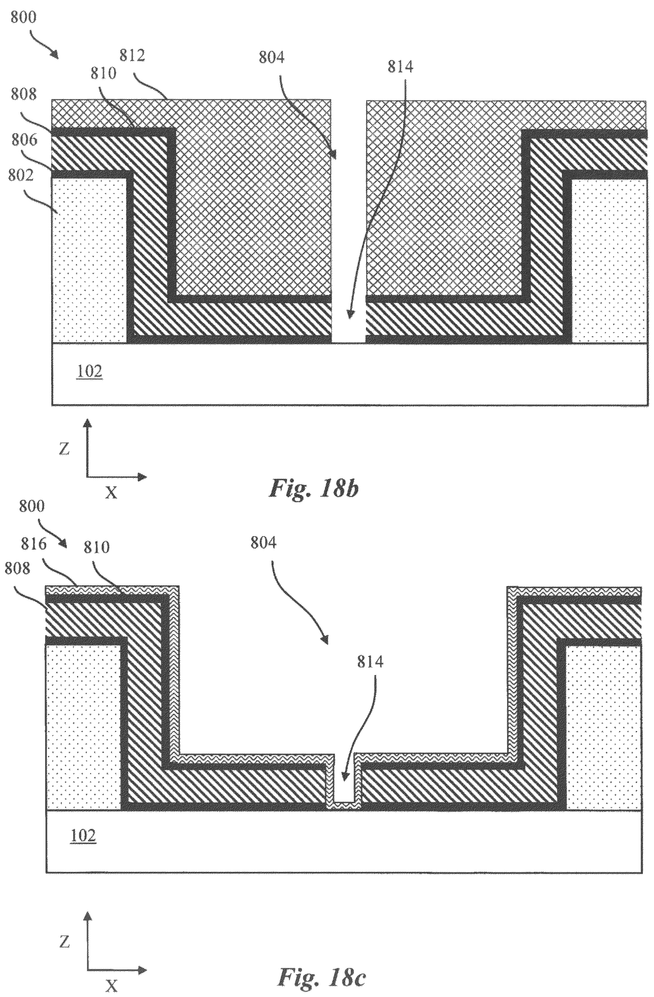

In Fig. 18b, the gate layer 808, the first partial gate dielectric layer 810 and (where present) the interfacial layer 806 have been patterned to define an auxiliary aperture 814 extending from the main aperture 804, through the gate layer 808, the first partial gate dielectric layer 810 and (where present) the interfacial layer 806, to expose a surface portion of the substrate 102. The auxiliary aperture 814 may be formed by etching the gate layer 808, the first partial gate dielectric layer 810 and the interfacial layer 806 using a patterned mask layer 812 as an etch mask. The mask layer 812 is in Fig. 18b shown in a schematic manner as a single layer, but may in practice be formed by a multi-layered lithographic layer stack, as per se is known in the art. Any conventional anisotropic wet or dry etching process or processes suitable for patterning narrow (e.g.., HAR) apertures in an oxide/poly-Silicon(/oxide) stack may be used.

In Fig. 18c, the mask layer 812 has been removed and a second partial gate dielectric layer 816 has been formed in the main aperture 804 and the auxiliary aperture 814, on top of the first partial gate dielectric layer 810, on a sidewall of the auxiliary aperture 814, and on the surface portion of the substrate 102 (previously) exposed in the auxiliary aperture 814. The sidewall of the auxiliary aperture 814 is as shown defined by the gate layer 808, the first partial gate dielectric layer 810 and the interfacial layer 806.

The second partial gate dielectric layer 816 may be formed by a same material and using a same type of process as the first partial gate dielectric layer 810.

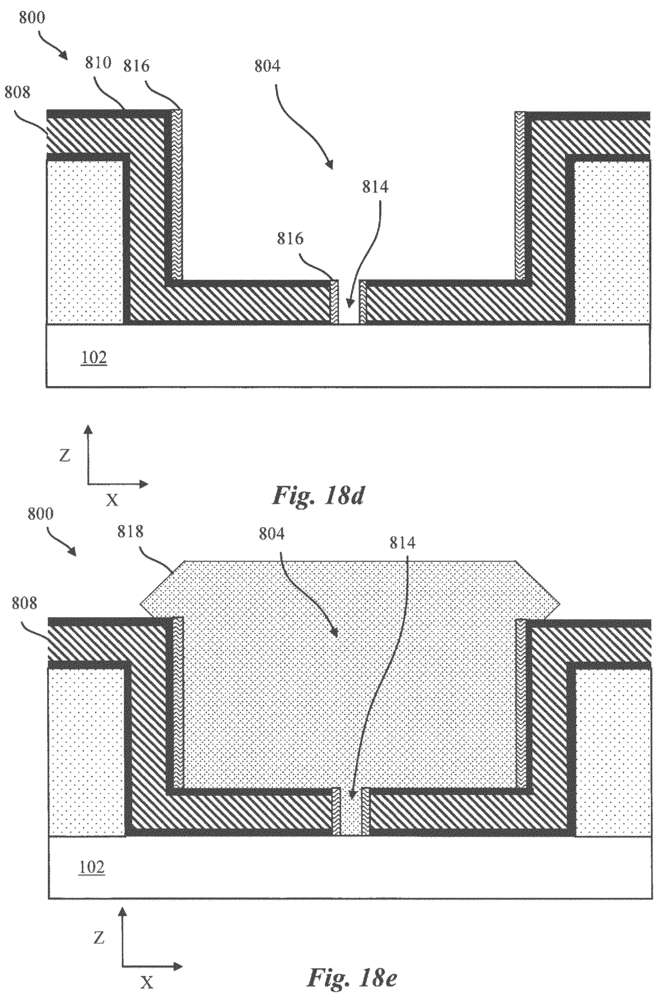

In Fig. 18d, the second partial gate dielectric layer 816 has been etched anisotropically in a top-down direction, to (re-)expose the surface portion of the substrate 102 at the bottom of the auxiliary aperture 814. Thus, the second partial gate dielectric layer 816 is removed from horizontally oriented surfaces and preserved on vertically oriented surfaces, that is on the first partial gate dielectric layer 810 on the sidewall of the main aperture 804, and on the gate layer 808 defining the sidewall of the auxiliary aperture 814. The remaining portions of the second partial gate dielectric layer 816, together with the first partial gate dielectric layer 810, together define the gate dielectric layer of the resulting pixel structure (e.g., corresponding to the gate dielectric layer 136 of the pixel structure 100 of Fig. 1a-b). Any conventional anisotropic wet or dry etching process suitable for etching a conformally deposited oxide may be used.

In Fig. 18e, a diode body 818 has been formed in the main and auxiliary apertures 804, 814 using a SEG process. More specifically, as the auxiliary aperture 814 defines a HAR aperture, the diode body 818 may initially be grown in the auxiliary aperture 814 using ART. The diode body 818 may be grown using epitaxial techniques which per se are known in the art, such as by CVD, metal-organic CVD (MOCVD), or molecular beam epitaxy (MBE). The diode body 818 may be grown from the surface portion of the substrate 102 exposed in the auxiliary aperture 814. The portion of the diode body 818 grown in the auxiliary aperture 814 may define the base portion of the diode body 818 (e.g., corresponding to the base portion 112 of the diode body 110 of the pixel structure 100 of Fig. 1a-b). The portion of the diode body 818 grown in the main aperture 804 may define the main portion of the diode body 818 (e.g., corresponding to the main portion 114 of the diode body 110 of the pixel structure 100 of Fig. 1a-b). The vertically oriented portions of the gate layer 808 extending along the sidewalls of the main aperture 804 may define a first gate portion (e.g., corresponding to the first gate portion 132 of the gate 130 of the pixel structure 100 of Fig. 1a-b). The horizontally oriented portion of the gate layer 808 protruding inwardly from the first gate portion, along the substrate 102, may define a second gate portion (e.g., corresponding to the second gate portion 134 of the gate 130 of the pixel structure 100 of Fig. 1a-b).

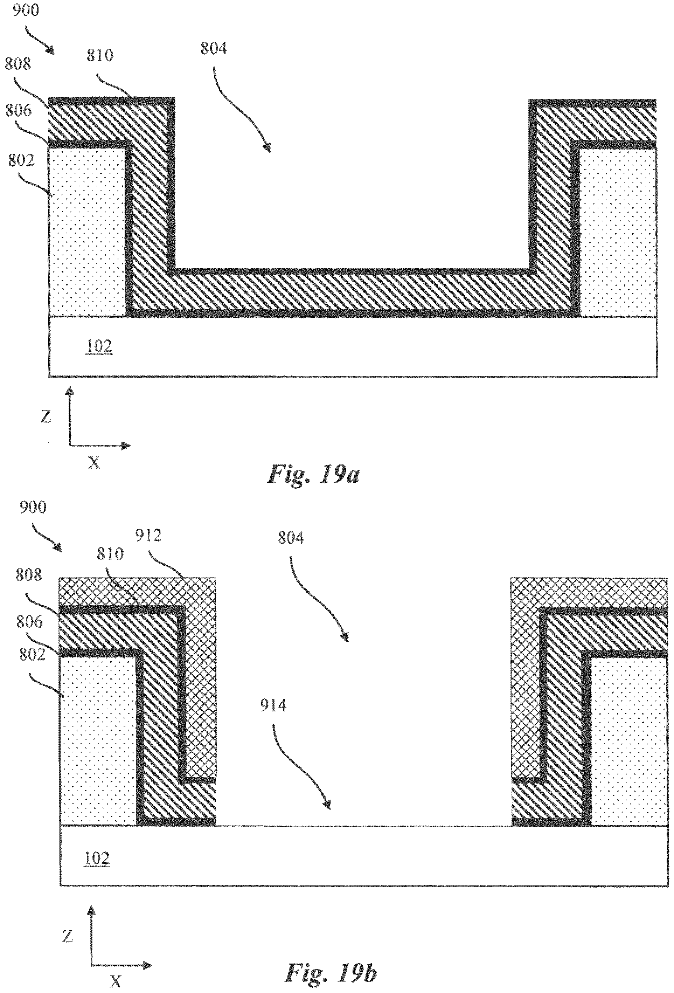

Fig. 19a-e schematically illustrate various stages of a further method for forming a pixel structure not using an ART-based process, such as a pixel structure corresponding to the pixel structure 200 of Fig. 12.

Fig. 19a shows an initial structure 900 which is to be subjected to further steps of the method to form a final pixel structure. Fig. 19a corresponds to Fig. 18a and the discussion of Fig. 18a applies correspondingly to Fig. 19a.

In Fig. 19b, the gate layer 808, the first partial gate dielectric layer 810 and (where present) the interfacial layer 806 have been patterned to define an auxiliary aperture 914 extending from the main aperture 804, through the gate layer 808, the first partial gate dielectric layer 810 and the interfacial layer 806, to expose a surface portion of the substrate 102. The device structure as shown in Fig. 19b generally corresponds to the device structure shown in Fig. 18b but differs in that the auxiliary aperture 914 is a LAR aperture in contrast to the HAR aperture 814. Analogous to the discussion of Fig. 18b, the aperture 914 may be formed by etching while using, as an etch mask, a patterned mask layer (stack) 912 corresponding to the mask layer 812 but differing in that the opening in the mask layer 912 may be formed with more relaxed dimension than the corresponding opening in the mask layer 812.

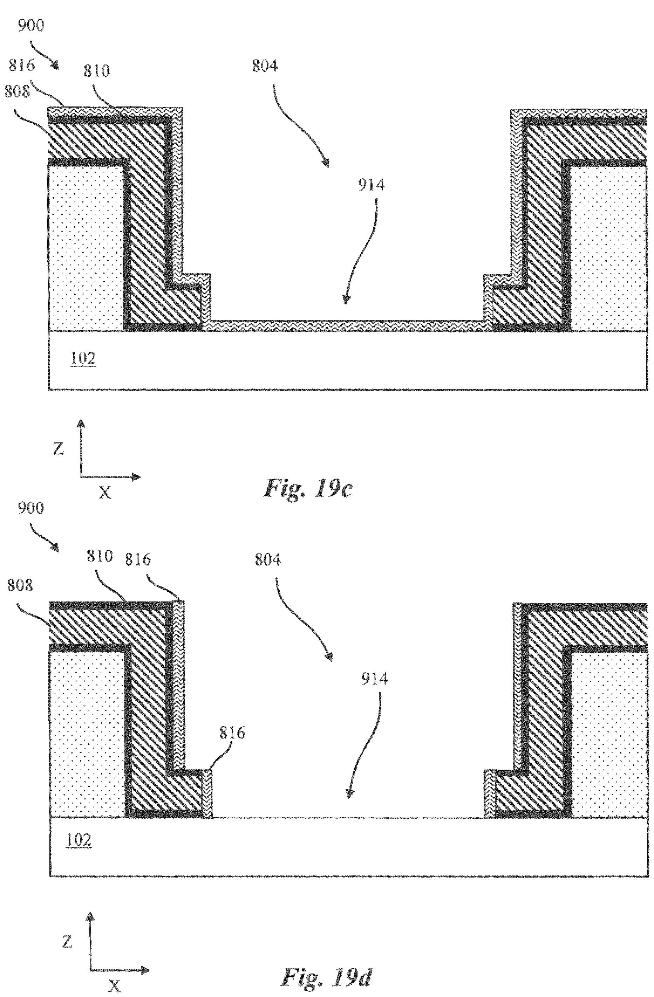

Fig. 19c corresponds to Fig. 18d and shows the device structure 900 after the mask layer 912 has been removed and a second partial gate dielectric layer 816 has been formed.

Fig. 19d corresponds to Fig. 18e and shows the device structure 900 after the second partial gate dielectric layer 816 has been etched anisotropically in a top-down direction, to (re-)expose the surface portion of the substrate 102 at the bottom of the auxiliary aperture 914.

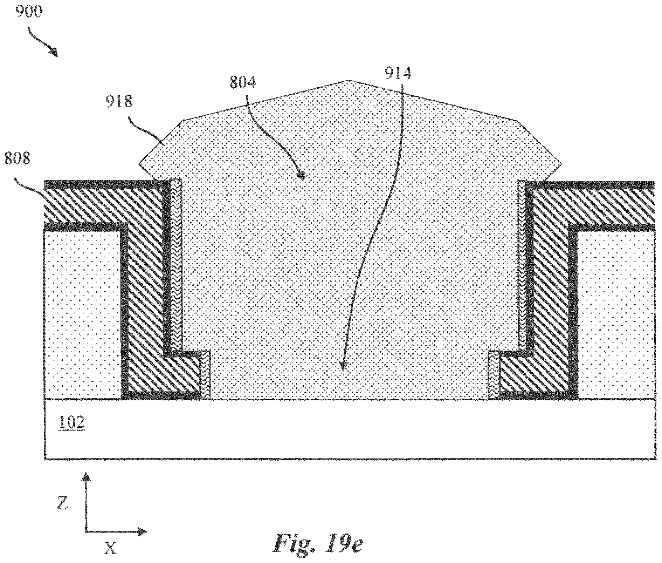

Fig. 19e, a diode body 918 has been formed in the main and auxiliary apertures 804, 914 using a SEG process. More specifically, as the auxiliary aperture 914 defines a LAR aperture, the diode body 818 may here be grown without using ART. The diode body 816 may be grown using epitaxial techniques which per se are known in the art, such as by CVD, MOCVD, or MBE. The portion of the diode body 918 grown in the auxiliary aperture 914 may define the base portion of the diode body 918 (e.g., corresponding to the base portion 112 of the diode body 110 of the pixel structure 200 of Fig. 12). The portion of the diode body 918 grown in the main aperture 804 may define the main portion of the diode body 918 (e.g., corresponding to the main portion 114 of the diode body 110 of the pixel structure 200 of Fig. 12). The vertically oriented portions of the gate layer 808 extending along the sidewalls of the main aperture 804 may define a first gate portion (e.g., corresponding to the first gate portion 132 of the gate 130 of the pixel structure 200 of Fig. 12). The horizontally oriented portion of the gate layer 808 protruding inwardly from the first gate portion, along the substrate 102, may define a second gate portion (e.g., corresponding to the second gate portion 134 of the gate 130 of the pixel structure 200 of Fig. 12).

As shown in both Fig. 18e and 19e, the respective diode bodies 818, 918 may be laterally and vertically overgrown outside of the main aperture 804. The protruding portions may subsequently be removed by a planarization process, such as using chemical mechanical polishing (CMP), to produce a pixel structure and diode body with a planar top surface.

During the planarization process, the horizontally extending portions of the gate layer 808, the first partial gate dielectric layer 810 and (where present) the interfacial layer 806 formed outside the main aperture 804 may also be removed, unless a common gate shared between neighboring pixel structures is to be formed.

Subsequently, either of the methods may proceed with forming first and second doped regions corresponding to regions 120, 122, depositing a passivation layer corresponding to passivation layer 106, and forming gate and diode terminals corresponding to terminals 138, 140, 142, to arrive at a pixel structure corresponding to the pixel structure 100 as shown in Fig. 1a-b or 2-11 (following the method of Fig. 18a-e) or the pixel structure 200 as shown in Fig. 12 (following the method of Fig. 19a-e). The method may further proceed with gate metal layer and diode metal layer deposition and patterning, using techniques which per se are known in the art.

The person skilled in the art realizes that the present invention by no means is limited to the examples described above. On the contrary, many modifications and variations are possible within the scope of the appended claims. For example, while the detailed description above refers to pixel structures based on a PIN diode implementation, the present disclosure is also applicable other diode implementations, such as, but not limited to, avalanche photo diodes (APD) and single-photon APD (SPAD). For instance, an APD or SPAD diode may be realized by forming the first doped region 120 in a further oppositely doped region formed in the central portion of the top portion 118 of the main portion 112 of the diode body 110 (e.g., a P-type region where the first doped region 120 is an N-type region, or vice versa). A PN junction may hence be defined underneath the first diode terminal. The further oppositely doped region may in turn be circumferentially surrounded by the intrinsic third region 124, separating the further oppositely doped region from the second doped region(s) 122.

## Claims

1. A pixel structure (100, 200, 500) comprising:
a substrate (102);
a diode body (110) comprising a base portion (112) protruding from the substrate (102) and a main portion (114) on top of the base portion (112), wherein a footprint of the base portion (112) is smaller than a footprint of the main portion (114), and wherein the main portion (114) comprises first and second oppositely doped regions (120, 122) formed in a top portion (118) of the main portion (114), wherein the first doped region (120) is formed in a central part of the footprint of the main portion (114) and the second doped region (122) is formed along a periphery of the footprint of the main portion (114);
a gate (130) arranged to circumferentially surround the diode body (110),
wherein the gate (130) comprises a first gate portion (132) surrounding the main portion (114) and a second gate portion (134) protruding inwardly from the first gate portion (132) to undercut the main portion (114) and surround the base portion (112);
a gate dielectric layer (136) arranged to separate the gate (130) and the diode body (110); and
a first diode terminal (140) contacting the first doped region (120), a second diode terminal (142) contacting the second doped region (122) and a gate terminal (138) contacting the gate (130).

2. The pixel structure (100, 200, 500) according to claim 1,
wherein the first and second diode terminals (140, 142) are configured to be biased with an anode voltage and a cathode voltage, respectively, or vice versa, and
wherein the gate terminal (138) is configured to be biased with a gate voltage such that a charge carrier layer (150) of free charge carriers of a same type as a majority carrier of the second doped region (122) is formed along a surface interface of the diode body (110) facing the gate (130).

3. The pixel structure (100, 200, 500) according to claim 2, wherein the charge carriers of the charge carrier layer (150) are at least in part sourced from the second doped region (122).

4. The pixel structure (100, 200, 500) according to any one of claims 2 and 3,
wherein the first doped region (120) is an N-type region, the second doped region (122) is a P-type region, the first diode terminal (140) is configured to be biased with a cathode voltage, the second diode terminal (142) is configured to be biased with an anode voltage lower than the cathode voltage, and the gate terminal (138) is configured to be biased with a gate voltage lower than the anode voltage; or
wherein the first doped region (120) is a P-type region, the second doped region (122) is an N-type region, the first diode terminal (140) is configured to be biased with an anode voltage, the second diode terminal (142) is configured to be biased with a cathode voltage higher than the anode voltage, and the gate terminal (138) is configured to be biased with a gate voltage higher than the cathode voltage.

5. The pixel structure (100) according to any one of the preceding claims, wherein a third region (124), being an intrinsic or low-doped region, is comprised in the top portion (118) of the diode body (110), circumferentially surrounding the first doped region (120) and separating the first doped region (120) from the second doped region (122).

6. The pixel structure (100) according to any one of the preceding claims, wherein the second doped region (122) extends along the full periphery of the footprint of the main portion (114), to circumferentially surround the first doped region (120).

7. The pixel structure (100) according to any one claims 1-5, wherein the top portion (118) of the main portion (114) comprises a plurality of spaced apart second doped regions (122, 122ah), doped oppositely to the first doped region (120), and distributed along the periphery of the footprint of the main portion (114), and wherein each second doped region (122, 122a-h) is contacted with the second diode terminal (142).

8. The pixel structure (100) according to claim 7, wherein each second doped region (122a-d) of the plurality of spaced apart second doped regions (122) is formed at a respective corner of the top portion (118).

9. The pixel structure (100) according to any one of the preceding claims, wherein the base portion (112) is a high aspect ratio structure.

10. The pixel structure (200) according to any one of claims 1-8, wherein the base portion (112) is a low aspect ratio structure.

11. The pixel structure (200) according to claim 10, wherein the base portion (112) comprises a doped bottom portion (126) abutting the substrate (102), the doped bottom portion (126) being of a same conductivity type as the second doped region (122).

12. The pixel structure (500) according to any one of the preceding claims, further comprising a gate metal layer (502) arranged over the gate (130) and contacting the gate terminal (138), wherein the gate metal layer (502) extends inwardly from a location above the first gate portion (132) to overlap a peripheral region of the footprint of the main portion (114).

13. The pixel structure (100, 200, 500) according to any one of the preceding claims, wherein the substrate (102) is formed of a group IV semiconductor, such as Si, and the diode body is formed of a group IV semiconductor, such as Ge, SiGe or GeSn, or a group III-V semiconductor, such as GaAs, InP, or InGaAs.

14. An array device (300, 400, 600, 700) comprising a plurality of pixel structures (100, 200, 500) according to any one of the preceding claims, arranged in a plurality of rows and columns.

15. A method for forming a pixel structure, comprising:
forming on a substrate (102), a diode device comprising:
a diode body (110) comprising a base portion (112) protruding from the substrate (102) and a main portion (114) on top of the base portion (112), wherein a footprint of the base portion (112) is smaller than a footprint of the main portion (114), and wherein the main portion (114) comprises first and second oppositely doped regions (120, 122) formed in a top portion (118) of the main portion (114), wherein the first doped region (120) is formed in a central part of the footprint of the main portion (114) and the second doped region (122) is formed along a periphery of the footprint of the main portion (114);
a gate (130) arranged to circumferentially surround the diode body (110), wherein the gate (130) comprises a first gate portion (132) surrounding the main portion (114) and a second gate portion (134) protruding inwardly from the first gate portion (132) to undercut the main portion (114) and surround the base portion (112);
a gate dielectric layer (136) arranged to separate the gate (130) and the diode body (110);
wherein the diode body (110) is formed using a selective epitaxial growth process subsequent to forming the gate (130) and the gate dielectric layer (136).
